# EUROPÄISCHE PATENTSCHRIFT

(11) **EP 1 673 578 B1**
(45) Veröffentlichungstag und Bekanntmachung des Hinweises auf die Patenterteilung: **30.12.2009**
(21) Anmeldenummer: 04790272.1
(22) Anmeldetag: 12.10.2004
(51) Int. Cl.: F24C 7/08, H03K 17/97

(54) **BEDIENVORRICHTUNG**
OPERATIONAL DEVICE
DISPOSITIF DE COMMANDE

(30) Priorität: 15.10.2003 DE 10348889
(43) Veröffentlichungstag der Anmeldung: 28.06.2006
(73) Patentinhaber: E.G.O. ELEKTRO-GERÄTEBAU GmbH, D-75038 Oberderdingen (DE)
(72) Erfinder: DORWARTH, Ralf, 75038 Oberderdingen (DE)
(74) Vertreter: Patentanwälte Ruff, Wilhelm, Beier, Dauster & Partner
(86) Internationale Anmeldenummer: PCT/EP2004/011371
(87) Internationale Veröffentlichungsnummer: WO 2005/038350

(56) Entgegenhaltungen:
- EP-A- 0 497 191
- EP-A- 0 797 227
- DE-A1- 10 035 592
- DE-A1- 19 645 907
- DE-A1- 19 906 365
- US-A- 3 711 672
- US-A- 3 852 558
- US-A- 4 317 016
- US-B1- 6 498 326

## Beschreibung

Die Erfindung betrifft eine Bedienvorrichtung gemäß dem Oberbegriff des Anspruchs 1, insbesondere für ein Elektrogerät wie beispielsweise ein Kochfeld.

Mit der Bedienvorrichtung soll vor allem eine Bedienbewegung entlang eines Bedienweges in ein Bediensignal umgesetzt werden, wobei der Bedienweg in verschiedene Bedienstufen oder Bedienarten aufgeteilt ist bzw. diese beispielsweise durch verschiedene Positionen entlang des Bedienweges eingestellt werden können.

Es sind beispielsweise aus der EP 12 20 570 A2 Bedienvorrichtungen bekannt, welche nach Art eines Linearschiebers aufgebaut sind. Es ist eine magnetische Kopplung zwischen einem oberhalb einer Abdeckung verlaufenden Magneten und einem darunter angeordneten Magnetfeld-Sensor vorgesehen. Durch die Bewegung des Linearschiebers können verschiedene Positionen festgestellt werden. Diese verschiedene Positionen können mit dem Magnetfeld-Sensor in ein jeweils gewünschtes Signal umgesetzt werden.

Dabei besteht das Problem, dass derartige linear zu betätigende Bedienvorrichtungen an vielen verschiedenen Geräten, insbesondere mit jeweils unterschiedlichen Abdeckungen, eingesetzt werden sollen. Durchbrüche für Schieber oder dergleichen sind manchmal nur schwer oder gar nicht anzubringen. Die Bedienung mit einem kontinuierlich schiebbaren Linearschieber ist auch nicht immer komfortabel oder genau genug.

Eine weitere Bedienvorrichtung nach dem Stand der Technik zeigt die US-A-3 852 558.

### Aufgabe und Lösung

Der Erfindung liegt die Aufgabe zugrunde, eine eingangs genannte Bedienvorrichtung zu schaffen, mit der die Nachteile des Standes der Technik vermieden werden können und insbesondere eine Bedienvorrichtung unabhängig von der Art der Anbringung oder einer Abdeckung ausgebildet sein kann und eine genaue Bedienung bzw. Bedienbewegung ermöglicht.

Gelöst wird diese Aufgabe durch eine Bedienvorrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß ist eine eingangs genannte Bedienvorrichtung auf einer Seite einer Abdeckung mit einem bewegbaren Bedienteil versehen, beispielsweise einem sogenannten Knebel. Dieser Bedienteil steht in einer kraftübertragenden Verbindung mit einem ersten bewegbaren Gegen-Teil, welches sich unter der Abdeckung befindet. Das erste Gegen-Teil wiederum befindet sich einer Rast-Anlage bzw. einer Rast-Wirkung mit einem zweiten Gegen-Teil, welches an der Unterseite der Abdeckung ortsfest, insbesondere starr, angeordnet ist. Zur Herstellung der Rast-Anlage bzw. Rast-Wirkung sind Vertiefungen und Vorsprünge, welche zueinander korrespondieren, entlang des Bedienweges mit Raststufen vorgesehen. Durch diese Vertiefungen und Vorsprünge können Abstand bzw. Aufteilung und Stärke der Rast-Anlage bzw. Rast-Wirkung beeinflusst und definiert werden. Des weiteren ist eine Sensoreinrichtung vorgesehen, welche die Bewegung des Bedienteils oder des ersten Gegen-Teils erfasst und in ein Bediensignal umsetzt. Dadurch kann erfasst werden, welche Art der Bedienung, also beispielsweise Bedienstufe oder Bedienart, ein Benutzer mit dem Bedienteil einstellen möchte.

Für die kraftübertragende Verbindung zwischen Bedienteil und erstem Gegen-Teil ist vorgesehen, diese mittels Magnetkraft auszugestalten. Dies bedeutet, mindestens ein Magnet und ein damit zusammenwirkendes magnetisches Teil, beispielsweise ebenso ein Magnet, wirken zusammen und übertragen die Bewegung des Bedienteils auf das erste Gegen-Teil.

Der Vorteil einer kraftübertragenden Verbindung mittels Magnetkraft liegt vor allem darin, dass eine Abdeckung nicht unterbrochen werden muß, wenn sie dünn genug ist, um die Magnetkraft für die kraftübertragende Verbindung in ausreichendem Maß zu übertragen. So können beispielsweise Glaskeramik-Kochfelder als Abdeckung verwendet werden. Hierfür müsste normalerweise ein Durchbruch geschaffen werden, was bei Glaskeramik sehr schwer und aufwendig ist. Die kraftübertragende Verbindung durch Magnetkraft ist immer noch so stark, um den mechanischen Widerstand gegen die Rast-Anlage bzw. Rast-Wirkung zu überwinden und eine sozusagen rastende Bewegung zu ermöglichen. Die rastende Bewegung wiederum weist den großen Vorteil auf, dass so eine Bewegung in vorgegebenen Schritten erfolgt. Die Bedienstellungen sind also relativ genau punktuell vorgegeben und auch leichter erfassbar. Eine rastende Bewegung gibt einem Bediener auch eine gute Rückmeldung über die Bedienbewegung in verschiedenen Stufen, vor allem dann, wenn solche verschiedenen Stufen gewünscht sind bei der speziellen Art der Bedienung.

In weiterer Ausgestaltung der Erfindung liegt das Bedienteil auf der Abdeckung an und ist daran verschiebbar. An der Unterseite der Abdeckung sitzt das zweite Gegen-Teil, entweder fest bzw. integral angeordnet oder ausgebildet oder daran befestigt. Das erste Gegen-Teil ist gemeinsam mit dem Bedienteil durch Magnetkraft verbunden und bewegbar.

Zur Herstellung der kraftübertragenden Verbindung durch Magnetkraft weisen das Bedienteil und/oder das erste Gegen-Teil einen Magneten auf. Beim Vorsehen lediglich eines Magneten kann das andere Teil ein mit diesem Magneten zusammenwirkendes Element aufweisen, beispielsweise ein Eisenstück oder dergleichen. Vorteilhaft weisen beide Teile einen Magneten auf. Besonders vorteilhaft kann das erste Gegen-Teil im wesentlichen vollständig ein Magnet sein.

Magnetische Materialien können eine Kobalt-Verbindung sein oder als Selten-Erd-Magnet vorgesehen sein, beispielsweise Kobalt-Samarium, AlNiCo oder aus Neodym. Diese magnetische Materialien zeichnen sich durch eine sehr hohe Magnetkraft bei gleichzeitig relativ geringer Baugröße aus.

Der Bedienweg bzw. die Rast-Anlage sind vorteilhaft länglich ausgebildet, beispielsweise an einer Art länglichen Schiene vorgesehen. Diese kann an die Unterseite der Abdeckung befestigt werden. Die Ausbildung der Rast-Anlage bzw. Rast-Wirkung kann vorsehen, dass zwischen fünf und zehn Vorsprüngen und Vertiefungen vorgesehen sind. Dies hängt jedoch vom gewünschten Einsatzgebiet der Bedienvorrichtung ab und kann auch durchaus mehr betragen.

Die Vertiefungen können abgerundet ausgebildet sein. Vorteilhaft sind sie in etwa teilkreisförmig, wobei eine Erstreckung über einen Bogenwinkel von maximal 90°, insbesondere zwischen 20° und 60°, als vorteilhaft angesehen werden. Die Vorsprünge wiederum sind vorteilhaft relativ schmal bzw. spitz ausgebildet. Dies bedeutet, dass die Einteilung in die verschiedenen Rast-Stufen relativ scharf und deutlich sein sollte. Sie können, insbesondere bei Verwendung einer vorgenannten Rast-Schiene, im wesentlichen nur von einer querverlaufenden Kante gebildet werden, auf welche die Vertiefungen zulaufen. Es ist des weiteren möglich, von einer Kante ausgehend die Vertiefungen zu beiden Seiten hin unterschiedlich auszubilden. Dadurch kann erreicht werden, dass die Rast-Wirkung unterschiedlich ist, abhängig von der Bewegungsrichtung.

Das erste Gegen-Teil kann rund ausgebildet sein. Sein Durchmesser bzw. seine Breite sollten kleiner sein als der Abstand zweier benachbarte Vorsprünge. So wird das erste Gegen-Teil durch die Magnetkraft entlang der Vertiefungen gezogen und die Einteilung in die verschiedenen Rast-Stufen ist für den Benutzer gut spürbar. In einer besonders einfachen Ausgestaltung der Erfindung ist das erste Gegen-Teil eine dicke Kreisscheibe, welche von der Magnetkraft gezogen an dem zweiten Gegen-Teil sozusagen entlang rollt bzw. sich mit der Außenkante daran entlang bewegt. So ist einerseits eine gute Bewegbarkeit gewährleistet und andererseits eine noch ausreichende Rast-Wirkung. Hier kann vorgesehen sein, dass Seiten oder Kanten der beiden Gegen-Teile, welche aneinander entlang laufen, rau oder gezackt sind, so dass sie nicht aneinander vorbeigleiten, sondern nach Art von Zahnrädern aneinander abrollen. So kann eine exakte definierte Rast-Wirkung erreicht werden.

An der Oberseite der Abdeckung, an welcher das Bedienteil entlang läuft, kann eine Führung dafür vorgesehen sein. Sie sollte zumindest in seitlicher Richtung formschlüssig sein bzw. eine Führung geben.

Gemäß einer bevorzugten Ausgestaltung der Erfindung ist eine Bedienvorrichtung für eine lineare Bedienbewegung ausgebildet, vorteilhaft geradlinig verlaufend. Bei einer anderen vorteilhaften Ausgestaltung der Erfindung ist der Bedienweg gebogen bzw. verläuft in zumindest Teilkreisform. Dabei kann das Bedienteil eine innerhalb des Bedienweges liegende Innenfläche überdecken und um eine Achse drehbar sein. Für die Drehbarkeit ist vorteilhaft eine Führung vorgesehen, welche mechanisch mittels einer Drehachse oder durch eine magnetische Zentrierung realisiert sein kann.

Die Sensoreinrichtung, mittels welcher die Bewegung des Bedienteils erfasst wird, kann magnetisch ausgelöst sein. Hierfür sind Magnet-Sensoren wie beispielsweise Hall-Sensoren vorteilhaft. Vor allem dann, wenn das bewegbare erste Gegen-Teil ein Magnet ist, kann dieser zur Auslösung der Sensorvorrichtung vorgesehen sein. Alternativ kann eine Sensoreinrichtung auch kapazitiv oder induktiv arbeiten oder optisch mit wenigstens einer Lichtschranke. Ebenso kann das erste Gegen-Teil wiederum mit einem Linear-Potentiometer oder dessen Schieber gekoppelt sein.

Diese und weitere Merkmale gehen außer aus den Ansprüchen auch aus der Beschreibung und der Zeichnung hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im folgenden näher erläutert. In den Zeichnungen zeigen:
- Fig. 1: eine schematische Schnittdarstellung durch eine erfindungsgemäße Bedienvorrichtung an einer Glaskeramikplatte und
- Fig. 2: einen Rast-Magnet nach Fig. 1 in Schrägansicht.

### Detaillierte Beschreibung des Ausführungsbeispiels

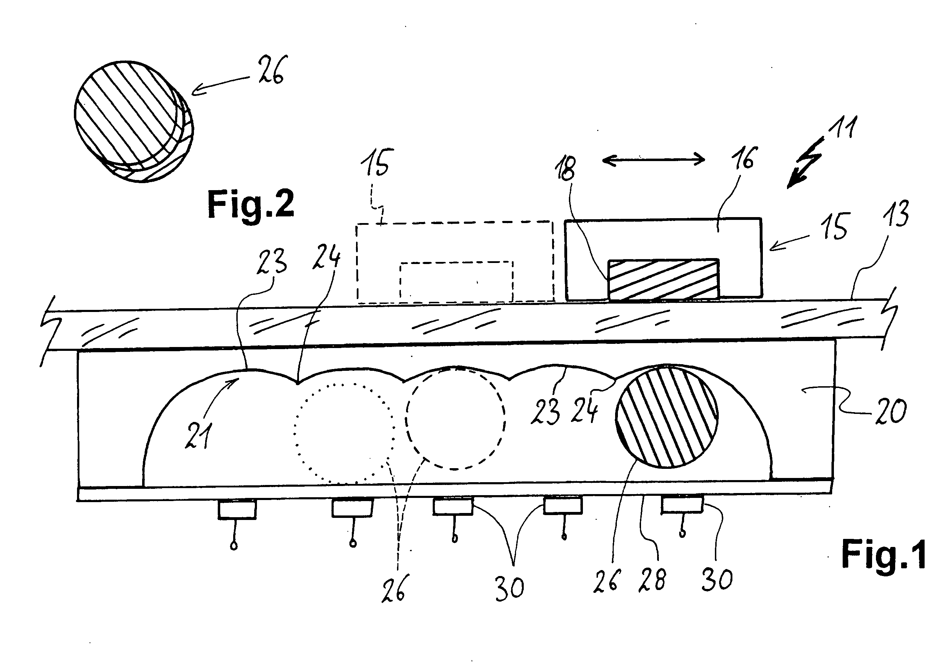

In Fig. 1 ist in schematischer Seiten- bzw. Schnittdarstellung eine erfindungsgemäße Bedieneinrichtung mit einem Schieberegler 11 dargestellt. Auf einer Glaskeramikplatte 13 kann ein Schiebeknebel 15 mit geradliniger Bewegung verschoben werden, wie es an sich von bekannten Linear- oder Schiebereglern bekannt ist. Der Schiebeknebel 15 weist ein Gehäuse 16 auf, an dessen Unterseite ein Schiebemagnet 18 sitzt.

Unterhalb der Glaskeramikplatte 13 ist eine Rast-Kulisse 20 mit einer Kulissenbahn 21 fest angeordnet. Die Kulissenbahn 21 besteht aus Vertiefungen 23 und Vorsprünge 24. Somit ergibt sich der wellenartige Verlauf der Kulissenbahn 21. Am Ende ist sie jeweils geschlossen und begrenzt so den Verschiebeweg.

Entlang der Kulissenbahn 21 wird der Rast-Magnet 26 bewegt, was nachfolgend noch genauer beschrieben wird. Die Form des Rast-Magnet 26 kann auch aus der Schrägdarstellung in Fig. 2 ersehen werden. Er ist nach Art einer kurzen Walze zylindrisch bzw. rundzylindrisch ausgebildet.

Nach unten zu ist die Rast-Kulisse 20 mit einer Abdeckung 28 versehen. Diese verhindert, dass der Rast-Magnet 26 bei Abheben des Schiebeknebels 15 und somit Unterbrechen der Kraftkopplung nach unten fällt. An der Unterseite der Abdeckung 28 sind Hall-Sensoren 30 vorgesehen, und zwar unterhalb jeder Vertiefung 23. Diese sprechen auf den Rast-Magnet 26 an. Sie zeigen somit an, in welcher Position bzw. an welcher Vertiefung 23 sich der Rast-Magnet 26 und somit auch in welcher Stellung sich der Schiebeknebel 15 befindet.

### Funktion

Wie aus der unterschiedlichen Schraffierung zu erkennen ist, sind der Schiebe-Magnet 18 und der Rast-Magnet 26 so ausgebildet, dass sie sich gegenseitig anziehen. Dies bedeutet, bei einer Bewegung des Schiebeknebels 15 wird gleichzeitig der Rast-Magnet 26 mitgezogen. Aufgrund der rundzylindrischen Ausbildung des Rast-Magneten führt dieser eine Bewegung an der Kulissenbahn 21 aus, welche je nach Art der Oberflächenausbildung ein Abrollen oder ein Entlanggleiten sein kann. Dabei ist leicht zu erkennen, wie die Vorsprünge 24 an der Kulissenbahn 21 ein gewisses Hindernis für die Bewegung des Rast-Magneten 26 darstellen. Die Magnetkraft zwischen Schiebe-Magnet 18 und Rast-Magnet 26 entspricht hier nämlich einer ansonsten für solche Rasteinrichtungen bekannten Druckfeder. Somit hat ein Bediener beim Verschieben des Schiebeknebels 15 den haptischen Eindruck, eine normale mechanische lineare Rasteinrichtung zu bedienen. Der große Vorteil der erfindungsgemäßen Bedienvorrichtung mit Rastung ist jedoch die Kopplung mittels Magnetkraft. Dies ermöglicht es beispielsweise, eine Glaskeramikplatte 13 zu benutzen ohne Durchbrüche oder dergleichen anbringen zu müssen. Somit entspricht dies im wesentlichen dem Grundprinzip der Erfindung.

Es ist in der gestrichelten Darstellung in Fig. 1 zu erkennen, wie der Rast-Magnet 26 an jeweils unterschiedlichen Stellen sein kann. Dies ist eben abhängig von der Position des Schiebeknebels 15. Mittels der Hall-Sensoren 30 erfolgt eine Feststellung der jeweiligen Position.

Als weitere Variationsmöglichkeiten können die Vertiefungen 23 und Vorsprünge 24 jeweils gleich, wie in Fig. 1 dargestellt, oder auch unterschiedlich ausgebildet sein. Es ist beispielsweise möglich, den letzten Vorsprung 24 bzw. die letzte Vertiefung 23 stärker auszuprägen, so dass diese letzte Rast-Stufe einen anderen, insbesondere größeren, Widerstand bietet als die anderen. Dies entspricht beispielsweise bei einer Bedienvorrichtung für ein Elektrokochfeld einer Zusatzstufe, beispielsweise für einen sogenannten Ankochstoß.

Die Abdeckung 28 hat neben der Anbringungsmöglichkeit für die Hall-Sensoren 30 noch die weitere Funktion, beim Abnehmen des Schiebeknebels 15 ein Herunterfallen des Rast-Magneten 26 in eine Position, in der die magnetische Kopplung nicht mehr hergestellt werden kann, zu verhindern. Dies ist in der punktierten Darstellung zu erkennen. Der Abstand zwischen Abdeckung 28 und der Kulissenbahn 21 bzw. den Vorsprüngen 24 sollte so gewählt werden, dass der Rast-Magnet 26 zwar noch problemlos passieren kann. Allerdings sollte er nicht so weit nach unten fallen können, dass die magnetische Kopplung nicht mehr hergestellt werden kann.

Des weiteren ist es möglich, die Abdeckung 28 nicht parallel zur Glaskeramikplatte 13 auszubilden wie in Fig. 1, sondern schräg dazu. Insbesondere kann sie derart schräg sein, dass der Rast-Magnet 26 selbsttätig bzw. automatisch in eine vorgegebene Position rollt oder gleitet, insbesondere nach ganz links oder nach ganz rechts. Dies hat den Vorteil, dass selbst beim Abnehmen des Schiebeknebels 15 oder einem ungewollten Schieben über eine Endposition hinaus der Rast-Magnet 26 in eine bestimmte vorgegebene Position selbsttätig zurückkehrt. Dort kann er dann mit dem Schiebeknebel 15 sozusagen wieder angekoppelt bzw. aufgenommen werden. Des weiteren kann vorgesehen sein, dass der dieser sogenannten Null-Position zugeordnete Hall-Sensor 30 so angesteuert und ausgewertet wird, dass bei Feststellen des Rast-Magneten 26 in dieser Position eine Null-Stellung als Bedienfunktion erkannt wird.

Anstelle der Hall-Sensoren 30 können auch sonstige Sensoren verwendet werden, entweder elektrische, beispielsweise optische, kapazitive oder induktive, oder mechanische, beispielsweise Mikroschalter.

Alternativ zu der fest angeordneten Rast-Kulisse 20 und dem bewegbaren Rast-Magneten 26 könnte auch vorgesehen sein, die Rast-Kulisse magnetisch und bewegbar auszubilden und den Rast-Magneten 26 als nichtmagnetisches, zumindest in Verschieberichtung nichtbewegbares Rast-Element auszubilden.

## Patentansprüche

1. Bedienvorrichtung (11), insbesondere für ein Elektrogerät wie beispielsweise ein Kochfeld, zur Umsetzung einer Bedienbewegung entlang eines Bedienweges mit Raststufen in ein Bediensignal, wobei der Bedienweg verschiedenen Bedienstufen oder Bedienarten entspricht, wobei die Bedienvorrichtung (11) auf einer Seite einer Abdeckung (13) einen bewegbaren Bedienteil (15) aufweist, der in einer kraftübertragenen Verbindung mittels Magnetkraft mit einem ersten bewegbaren Gegen-Teil (26) unter der Abdeckung steht, wobei ein zweites Gegen-Teil (20) an der Unterseite der Abdeckung (13) ortsfest angeordnet ist, wobei eine Sensoreinrichtung (30) vorgesehen ist, die die Bewegung des Bedienteils (15) oder des ersten Gegen-Teils (26) erfasst und in ein Bediensignal umsetzt, **dadurch gekennzeichnet daß** sich das erste Gegen-Teil für die Raststufen in Rast-Anlage befindet mit dem zweiten Gegen-Teil (20), wobei das als Rast-Anlage wirkende zweite Gegen-Teil (20) Vertiefungen (23) und Vorsprünge (24) entlang des Bedienweges aufweist.

2. Bedienvorrichtung nach Anspruch 1, **dadurch gekennzeichnet, dass** das Bedienteil (15) auf der Abdeckung (13) anliegend entlang verschiebbar ist, wobei an der Unterseite der Abdeckung das zweite Gegen-Teil (20) fest angeordnet ist oder daran ausgebildet ist und die Rast-Anlage mit den Vorsprüngen (24) und Vertiefungen (23) aufweist.

3. Bedienvorrichtung nach Anspruch 1 oder 2, **dadurch gekennzeichnet, dass** das Bedienteil (15) und/oder das erste Gegen-Teil (26) einen Magneten (18, 26) aufweist, wobei vorzugsweise das erste Gegen-Teil im wesentlichen vollständig ein Magnet ist.

4. Bedienvorrichtung nach einem der vorhergehenden Ansprüche, **gekennzeichnet durch** einen Magneten (18, 26) aus CoSm, AlNiCo oder Nd, vorzugsweise mit einer Kobalt-Verbindung oder als Selten-Erd-Magnet.

5. Bedienvorrichtung nach einem der vorhergehenden Ansprüche, **dadurch gekennzeichnet, dass** die Rast-Anlage (20) länglich ausgebildet ist, insbesondere an einer länglichen Schiene vorgesehen.

6. Bedienvorrichtung nach einem der vorhergehenden Ansprüche, **dadurch gekennzeichnet, dass** die Vertiefungen (23) abgerundet sind, vorzugsweise teilkreisförmig sind und sich über einen Bogenwinkel von 20° bis 60° erstrecken.

7. Bedienvorrichtung nach einem der vorhergehenden Ansprüche, **dadurch gekennzeichnet, dass** die Vorsprünge (24) schmal bzw. spitz sind, wobei sie vorzugsweise im wesentlichen nur von einer quer zur Längsrichtung der Rast-Anlage verlaufenden Kante gebildet sind.

8. Bedienvorrichtung nach einem der vorhergehenden Ansprüche, **dadurch gekennzeichnet, dass** das erste Gegen-Teil (26) rund ist, vorzugsweise kreisrund, wobei insbesondere der Durchmesser des ersten Gegen-Teils kleiner ist als der Abstand zweier benachbarter Vorsprünge (24).

9. Bedienvorrichtung nach einem der vorhergehenden Ansprüche, **dadurch gekennzeichnet, dass** das erste Gegen-Teil (26) als Kreisscheibe ausgebildet ist, wobei vorzugsweise die Dicke mindestens 30% des Durchmessers beträgt.

10. Bedienvorrichtung nach einem der vorhergehenden Ansprüche, **dadurch gekennzeichnet, dass** die Abdeckung (13) geschlossen und ohne Durchbrüche ausgebildet ist.

11. Bedienvorrichtung nach einem der vorhergehenden Ansprüche, **dadurch gekennzeichnet, dass** die Rast-Anlage geradlinig verläuft.

12. Bedienvorrichtung nach einem der Ansprüche 1 bis 10, **dadurch gekennzeichnet, dass** der Bedienweg gebogen ist, insbesondere teilkreisförmig gebogen ist, wobei er vorzugsweise kreisförmig verläuft und das Bedienteil eine der Fläche innerhalb des Bedienwegs liegenden Innenfläche überdeckt und um eine Achse drehbar ist, insbesondere mit einer mechanischen Führung geführt, welche durch die Mitte des kreisförmigen Bedienwegs verläuft.

13. Bedienvorrichtung nach einem der vorhergehenden Ansprüche, **dadurch gekennzeichnet, dass** die Sensoreinrichtung magnetisch ausgelöst ist, vorzugsweise mit mindestens einem MagnetSensor, insbesondere einem Hall-Sensor (30).

14. Bedienvorrichtung nach einem der Ansprüche 1 bis 12, **dadurch gekennzeichnet, dass** die Sensoreinrichtung optisch arbeitet mit einer Lichtschranke.

## Claims

1. Operational device (11), in particular for an electric appliance such as a hob, for converting an operating movement along an operating distance with engagement steps into an operating signal, where the operating distance has various operating stages or operating types, where the operational device (11) has on one side of a cover (13) a movable operating part (15) that by means of magnetic force is in a power-transmitting connection to a first movable associated part (26) underneath the cover, where a second associated part (20) is arranged stationarily on the underside of the cover (13), where a sensor device (30) is provided that detects the movement of the operating part (15) or of the first associated part (26) and converts it into an operating signal, **characterized in that** the first associated part for the engagement steps is in an engagement system with the second associated part (20), where said second associated part (20) acting as the engagement system has recesses (23) and projections (24) along the operating distance.

2. Operational device according to Claim 1, **characterized in that** the operating part (15) contacting the cover (13) is movable along it, where the second associated part (20) is firmly arranged on or integral with the underside of the cover and incorporates the engagement system with the projections (24) and recesses (23).

3. Operational device according to Claim 1 or 2, **characterized in that** the operating part (15) and/or the first associated part (26) has a magnet (18, 26), where preferably the first associated part is substantially entirely a magnet.

4. Operational device according to one of the preceding claims, **characterized by** a magnet (18, 26) made of CoSm, AlNiCo or Nd, preferably with a cobalt compound or as a rare earth magnet.

5. Operational device according to one of the preceding claims, **characterized in that** the engagement system (20) is designed elongated, in particular disposed on an elongated rail.

6. Operational device according to one of the preceding claims, **characterized in that** the recesses (23) are rounded, preferably partially circular, and extend over an arc angle of 20° to 60°.

7. Operational device according to one of the preceding claims, **characterized in that** the projections (24) are narrow or pointed, preferably being formed substantially only by an edge running transversely to the longitudinal direction of the engagement system.

8. Operational device according to one of the preceding claims, **characterized in that** the first associated part (26) is round, preferably circular, where in particular the diameter of the first associated part is smaller than the distance between two adjacent projections (24).

9. Operational device according to one of the preceding claims, **characterized in that** the first associated part (26) is designed as a circular disc, where the thickness is preferably at least 30% of the diameter.

10. Operational device according to one of the preceding claims, **characterized in that** the cover (13) is designed closed and without apertures.

11. Operational device according to one of the preceding claims, **characterized in that** the engagement system runs in a straight line.

12. Operational device according to one of Claims 1 to 10, **characterized in that** the operating distance is curved, in particular with a partially circular curve, where it runs preferably circular and the operating part covers an inner surface within the operating distance and is rotatable about an axis, in particular guided by a mechanical guide running through the centre of the circular operating distance.

13. Operational device according to one of the preceding claims, **characterized in that** the sensor device is triggered magnetically, preferably by at least one magnetic sensor, in particular by a Hall sensor (30).

14. Operational device according to one of Claims 1 to 12, **characterized in that** the sensor device operates optically with a light barrier.

## Revendications

1. Dispositif de commande (11), en particulier pour un appareil électrique tel qu'une plaque de cuisson, destiné à transformer en un signal de commande un mouvement de commande le long d'une course de commande avec positions de crantage, sachant que la course de commande correspond à différents régimes ou types de commande, que le dispositif de commande (11) présente sur une face d'un élément de recouvrement (13) un organe de commande (15) qui est en liaison transmettant la force magnétique avec une première pièce complémentaire mobile (26) située sous l'élément de recouvrement, qu'une deuxième pièce complémentaire (20) est disposée en position fixe sur la face inférieure de l'élément de recouvrement (13), qu'est prévu un dispositif de captage (30) qui enregistre le mouvement de l'organe de commande (15) ou de la première pièce complémentaire (26) et le transforme en un signal de commande, **caractérisé en ce que** la première pièce complémentaire se trouve dans le dispositif à crans pour les positions de crantage avec la deuxième pièce complémentaire (20), sachant que la deuxième pièce complémentaire (20) agissant comme dispositif à crans présente des évidements (23) et des parties saillantes (24) le long de la course de commande.

2. Dispositif de commande selon la revendication 1, **caractérisé en ce que** l'organe de commande (15) s'appliquant sur l'élément de recouvrement (13) peut être déplacé le long de celui-ci, sachant que sur la face inférieure de l'élément de recouvrement, la deuxième pièce complémentaire (20) est disposée en position fixe ou formée dans ladite face et présente le dispositif à crans avec les parties saillantes (24) et les évidements (23).

3. Dispositif de commande selon la revendication 1 ou 2, **caractérisé en ce que** l'organe de commande (15) et/ou la première pièce complémentaire (26) présente un aimant (18, 26), sachant que de préférence la première pièce complémentaire est pour l'essentiel intégralement un aimant.

4. Dispositif de commande selon l'une des revendications précédentes, **caractérisé par** un aimant (18, 26) en CoSm, AlNiCo ou Nd, de préférence avec une combinaison cobalt ou sous forme d'aimant de terre rare.

5. Dispositif de commande selon l'une des revendications précédentes, **caractérisé en ce que** le dispositif à crans (20) a une forme oblongue et est en particulier prévu sur un rail allongé.

6. Dispositif de commande selon l'une des revendications précédentes, **caractérisé en ce que** les évidements (23) sont arrondis, ont de préférence la forme de cercles partiels et s'étendent sur un arc de cercle compris entre 20° et 60°.

7. Dispositif de commande selon l'une des revendications précédentes, **caractérisé en ce que** les parties saillantes (24) sont étroites ou effilées, sachant qu'elles ne sont formées de préférence que par une arête du dispositif à crans s'étendant pour l'essentiel transversalement par rapport au sens longitudinal du dispositif à crans.

8. Dispositif de commande selon l'une des revendications précédentes, **caractérisé en ce que** la première pièce complémentaire (26) est ronde, de préférence circulaire, sachant qu'en particulier le diamètre de la première pièce complémentaire est inférieur à la distance entre deux parties saillantes (24) voisines.

9. Dispositif de commande selon l'une des revendications précédentes, **caractérisé en ce que** la première pièce complémentaire (26) a la forme d'un disque circulaire, sachant que de préférence l'épaisseur est au moins égale à 30 % du diamètre.

10. Dispositif de commande selon l'une des revendications précédentes, **caractérisé en ce que** l'élément de recouvrement (13) est fermé et ne présente pas d'ouverture.

11. Dispositif de commande selon l'une des revendications précédentes, **caractérisé en ce que** le dispositif à crans s'étend en ligne droite.

12. Dispositif de commande selon l'une des revendications 1 à 10, **caractérisé en ce que** la course de commande est incurvée, en particulier en forme de cercle partiel, sachant qu'elle s'étend de préférence de manière circulaire et que l'organe de commande recouvre une des surfaces intérieures situées dans les limites de la course de commande et peut être pivoté autour d'un axe, en particulier avec un guide mécanique qui passe par le centre de la course de commande circulaire.

13. Dispositif de commande selon l'une des revendications précédentes, **caractérisé en ce que** le dispositif de captage se déclenche magnétiquement, de préférence avec un capteur magnétique, en particulier un capteur à effet Hall (30).

14. Dispositif de commande selon l'une des revendications 1 à 12, **caractérisé en ce que** le dispositif de captage travaille optiquement avec une barrière lumineuse.
